# EUROPEAN PATENT APPLICATION

(11) **EP 4 258 370 A1**
(43) Date of publication of application: **11.10.2023**
(21) Application number: 23164321.4
(22) Date of filing: 27.03.2023
(51) Int. Cl.: H01L 33/58, H01L 33/50

(54) **LIGHT-EMITTING DEVICE**

(30) Priority: 31.03.2022 JP 2022059466; 21.10.2022 JP 2022169324; 03.03.2023 JP 2023033021
(71) Applicant: Nichia Corporation, Anan-shi, Tokushima 774-8601 (JP)
(72) Inventor: ISHII, Takashi, Anan-shi, Tokushima, 774-8601 (JP); WAKAKI, Takayoshi, Anan-shi, Tokushima, 774-8601 (JP); MUSASHI, Naoki, Anan-shi, Tokushima, 774-8601 (JP)
(74) Representative: Winter, Brandl - Partnerschaft mbB

(57) **Abstract**

A light-emitting device includes a substrate, a light-emitting element on the substrate, a wavelength conversion member on the light-emitting element and including a first surface, an optical member above the first surface, a light-transmitting layer between the wavelength conversion member and the optical member and having a refractive index lower than a refractive index of the optical member, and a light-reflecting member surrounding the light-emitting element, the wavelength conversion member, the light-transmitting layer, and the optical member. The upper surface of the optical member includes a first region and a second region adjacent to the first region. The first region includes a first exit surface of which internal angle relative to the first surface is a first angle. The second region includes a second exit surface having a second angle narrower than the first angle. The second region is located in one corner region of the optical member.

## Description

### FIELD

Embodiment relates to a light-emitting device.

### BACKGROUND

A light-emitting device can emit light of higher brightness by narrowing light distribution. A known structural body for narrowing the light distribution of the light-emitting device includes a textured optical member provided above a wavelength conversion layer disposed on a light-emitting element (see PCT Publication No. WO2017/069964). In the light-emitting device disclosed in this PCT Publication, a narrower light distribution is achieved by providing a layer of air between the wavelength conversion layer and the optical member.

### BRIEF DESCRIPTION OF THE DRAWINGS

FIG. 1 schematically illustrates a top view of a light-emitting device according to an embodiment.
FIG. 2 schematically illustrates a cross-sectional view of the light-emitting device according to the embodiment taken along line II-II in FIG. 1.
FIG. 3 schematically illustrates a cross-sectional view of the light-emitting device according to the embodiment taken along line III-III in FIG. 1.
FIG. 4A schematically illustrates an enlarged top view of a portion IVA of the light-emitting device in FIG. 1.
FIG. 4B schematically illustrates an enlarged cross-sectional view of a part of the portion IVA taken along line IVB-IVB in FIG. 4A.
FIG. 4C schematically illustrates an enlarged perspective view of a part of the portion IVA in FIG. 4A.
FIG. 5A schematically illustrates an enlarged top view of a light-emitting device according to a variation of the embodiment.
FIG. 5B schematically illustrates a cross-sectional view of the light-emitting device according to the variation taken along line VB-VB in FIG. 5A.
FIG. 6 is a schematic cross-sectional diagram to explain light emission of the light-emitting device according to the embodiment.
FIG. 7A is a schematic cross-sectional diagram to explain light emission of the light-emitting device according to the embodiment.
FIG. 7B is a schematic cross-sectional diagram to explain light emission of a light-emitting device according to a comparative example.
FIG. 7C is another schematic cross-sectional diagram to explain light emission of the light-emitting device according to the embodiment.
FIG. 8A schematically illustrates an enlarged top view of a part of the light-emitting device according to the comparative example, to explain light emission thereof.
FIG. 8B schematically illustrates a cross-sectional view of a part of the light-emitting device according to the comparative example taken along line VIIIB-VIIIB in FIG. 8A, to explain light emission thereof.
FIG. 9A schematically illustrates an enlarged top view of a part of the light-emitting device according to the embodiment to explain light emission thereof.
FIG. 9B schematically illustrates a cross-sectional view of a part of the light-emitting device according to the embodiment taken along line IXB-IXB in FIG. 9A, to explain light emission thereof.
FIG. 10 is a schematic top view diagram to explain definitions of parameters related to brightness of the light-emitting device according to the embodiment.
FIG. 11 is a graph presenting relative brightness according to the definitions of the parameters.
FIG. 12A schematically illustrates a top view of a light-emitting device according to a variation of the embodiment.
FIG. 12B schematically illustrates a top view of a light-emitting device according to another variation of the embodiment.
FIG. 13A schematically illustrates a top view of a light-emitting device according to still another variation of the embodiment.
FIG. 13B schematically illustrates a top view of a light-emitting device according to still another variation of the embodiment.
FIG. 14A schematically illustrates a top view of a light-emitting device according to still another variation of the embodiment.
FIG. 14B schematically illustrates a top view of a light-emitting device according to still another variation of the embodiment.

### DETAILED DESCRIPTION

One or more embodiments of the present invention will be described below with reference to the drawings.

Note that the drawings are schematic or conceptual, and the relationships between thicknesses and widths of portions, the proportions of sizes between portions, and the like are not necessarily the same as the actual values thereof. Furthermore, the dimensions and the proportions may be illustrated differently among the drawings, even in a case in which the same element or a portion there of is illustrated.

It is noted that, in the description and the drawings, elements the same as or similar to those described in relation to a drawing therein above are denoted using like reference characters, and a detailed description is omitted as appropriate. As a cross-sectional view, an end view illustrating only a cutting surface may be used.

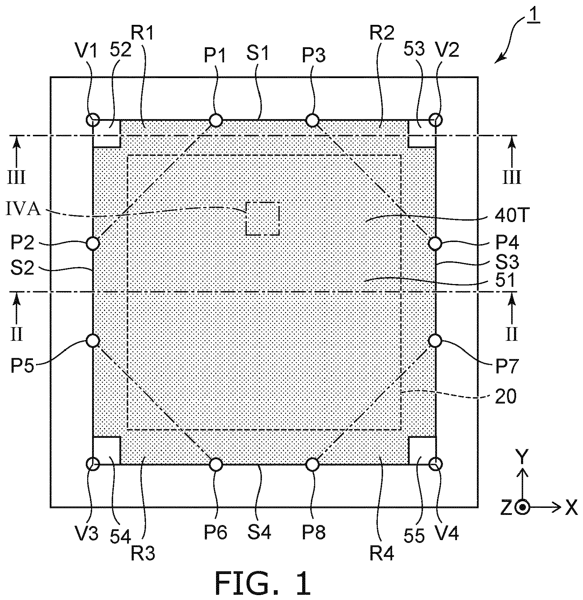

FIG. 1 schematically illustrates a top view of a light-emitting device according to an embodiment.

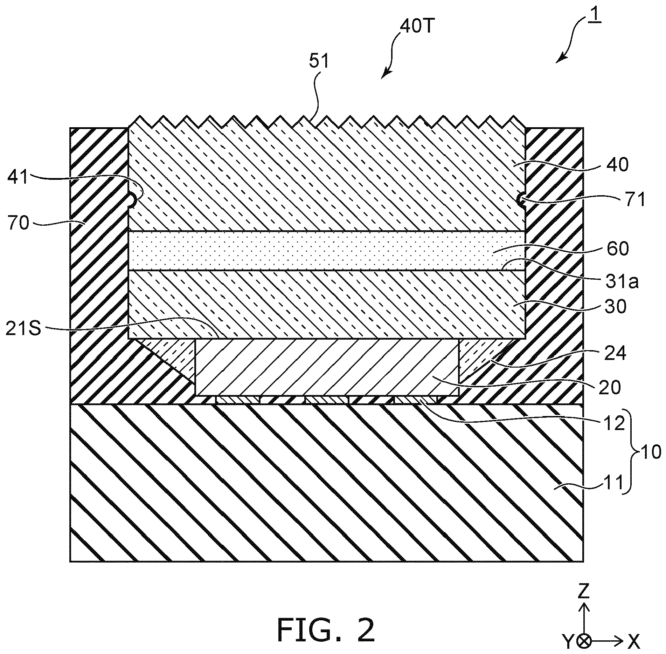

FIG. 2 schematically illustrates a cross-sectional view of the light-emitting device according to the embodiment taken along line II-II in FIG. 1.

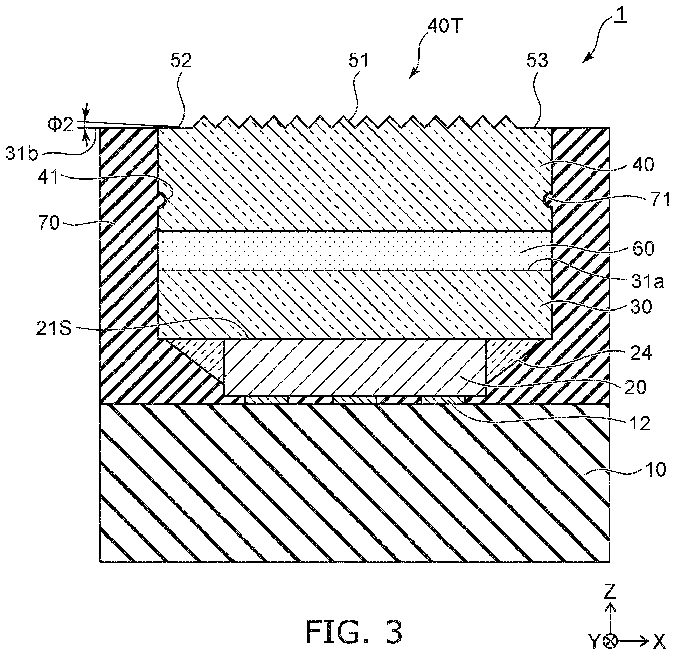

FIG. 3 schematically illustrates a cross-sectional view of the light-emitting device according to the embodiment taken along line III-III in FIG. 1.

As illustrated in FIGS. 1 to 3, a light-emitting device 1 according to the present embodiment includes a substrate 10, a light-emitting element 20, a wavelength conversion member 30, an optical member 40, a light-transmitting layer 60, and a light-reflecting member 70.

The light-emitting element 20 is disposed on the substrate 10. The wavelength conversion member 30 is disposed on the light-emitting element 20. The wavelength conversion member 30 includes a first surface 31a, and the light-emitting element 20 is disposed facing a surface of the wavelength conversion member 30 opposite to the first surface 31a. The light-emitting element 20 includes a light emitting surface 21S. The light emitting surface 21S faces the surface of the wavelength conversion member 30 opposite to the first surface 31a. The light emitting surface 21S is a surface from which the light-emitting element 20 mainly emits light. The first surface 31a and the light emitting surface 21S are parallel to each other.

In the following description, a three-dimensional XYZ coordinate may be used. An XY plane is assumed to be a plane parallel to the first surface 31a and the light emitting surface 21S. The direction of an X-axis and the direction of a Y-axis can be discretionarily chosen. The optical member 40 has a square outer periphery in a XY plan view. In that case, it is assumed that the X-axis is parallel to a first side portion S1, which is one of four sides of the outer periphery of the optical member 40, and the Y-axis is parallel to a second side portion S2 orthogonal to the first side portion S1 of the four sides of the outer periphery of the optical member 40 and next to the first side portion S1. It is assumed that a Z-axis is orthogonal to the X-axis and the Y-axis, and the direction toward the first surface 31a from the surface of the wavelength conversion member 30 located opposite to the first surface 31a is referred to as a positive direction. In the present disclosure, the term "parallel" means that two straight lines, sides, surfaces, or the like are in a range of approximately 0 degrees ±5%.

The positive direction of the Z-axis may be referred to as "up", "upper", or "above", and the negative direction of the Z-axis may be referred to as "down", "lower", or "below". When the light-emitting device 1 is viewed from above, it may be referred to as "top view". Furthermore, when viewed from above and when viewed from below are not distinguished from each other, it may be referred to as "XY plan view" or simply "plan view". The direction along the Z-axis is not necessarily the direction in which gravity is applied. These are for facilitating the understanding of the description and are not limited to the actual "up", "upper", "above", "down", "lower" and "below". The length in the Z-axis direction may be referred to as a thickness.

As illustrated in FIG. 2, the optical member 40 is disposed above the first surface 31a of the wavelength conversion member 30. The optical member 40 includes an upper surface 40T. The optical member 40 is disposed so that a surface located opposite to the upper surface 40T faces the first surface 31a. In the example illustrated in FIG. 2, the optical member 40 has the same shape as the wavelength conversion member 30 in the top view. The optical member 40 and the wavelength conversion member 30 are arranged to overlap each other. In the top view, the shape of the optical member 40 may be different from the shape of the wavelength conversion member 30.

The light-transmitting layer 60 is disposed between the wavelength conversion member 30 and the optical member 40. The light-transmitting layer 60 has a refractive index lower than a refractive index of the optical member 40.

The light-reflecting member 70 surrounds the light-emitting element 20, the wavelength conversion member 30, the light-transmitting layer 60, and the optical member 40 in the XY plan view.

The configuration of the optical member 40 is described in detail.

As illustrated in FIG. 1, the upper surface 40T of the optical member 40 includes a first region 51 and a second region 52. The upper surface 40T of the optical member 40 further includes a third region 53, a fourth region 54, and a fifth region 55.

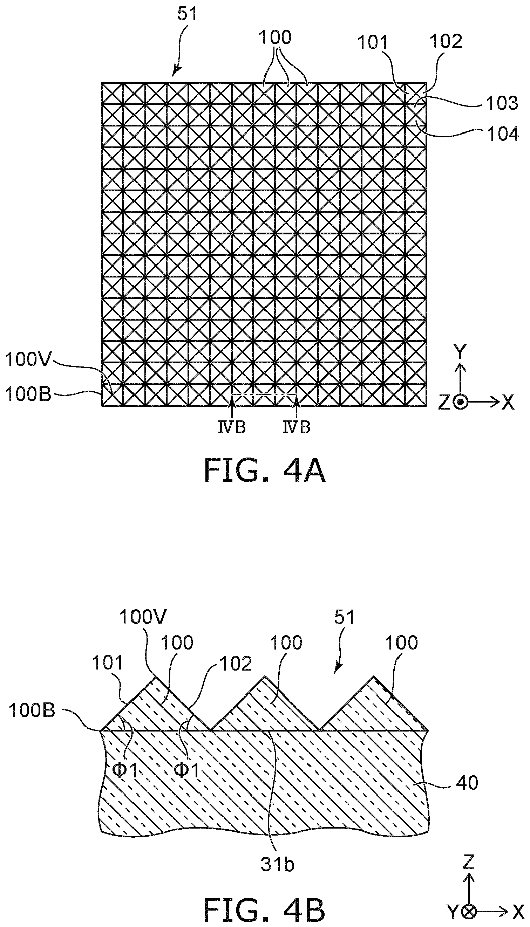

In the example illustrated in FIG. 1, the first region 51 occupies most of the upper surface 40T including a central portion and a peripheral portion thereof. In the example, a center (e.g., centroid) of the shape of the upper surface 40T is in the central portion. The first region 51 includes structural bodies 100 illustrated in FIG. 4A to be described below. The structural bodies 100 each include an inclined surface (first exit surface) 101. As illustrated in FIG. 4B, the inclined surface 101 has a first angle ϕ1 relative to a virtual plane 31b parallel to the first surface 31a. The first angle ϕ1 is preferably in a range from 40° to 50°. A part of light passing through the optical member 40 exits from the inclined surface 101 of the first region 51.

As illustrated in FIG. 1, the second region 52 is adjacent to the first region 51. The third region 53, the fourth region 54, and the fifth region 55 each are also adjacent to the first region 51. The first region 51 is located between the second region 52 and the third region 53. The first region 51 is located between the second region 52 and the fourth region 54. The first region 51 is located between the third region 53 and the fifth region 55. The first region 51 is located between the fourth region 54 and the fifth region 55. That is, the second region 52 to the fifth region 55 are not adjacent to one another.

The second region 52 may include or does not have to include one or more structural bodies. When the second region 52 includes one or more structural bodies, the one or more structural bodies include a light exit surface (i.e., second exit surface). The exit surface has a second angle ϕ2 relative to the first surface 31a. FIG. 3 illustrates a virtual plane 3 1b parallel to the first surface 31a and illustrates that the exit surface has the second angle ϕ2 relative to the plane 31b. The second angle ϕ2 is narrower than the first angle ϕ1, preferably is narrower than 40° relative to the first surface 31a. When the second region 52 includes no structural body, a flat surface parallel to the first surface 31a (that is, the flat surface at a second angle, which is preferably 0°±5°, relative to the first surface 31a) serves as the light exit surface (i.e., second exit surface). A part of light transmitted through the optical member 40 exits to an external space using the second region 52 as the exit surface (i.e., second exit surface).

The third region 53 to the fifth region 55 each may include or does not have to include a structural body, similarly to the second region 52. The structural bodies of the third region 53 to the fifth region 55 each include a light exit surface, and these exit surfaces have a third angle, a fourth angle, and a fifth angle relative to the first surface 31a, respectively. The third angle to the fifth angle are narrower than the first angle. The third angle to the fifth angle are preferably narrower than 40° relative to the first surface 31a, similarly to the second angle ϕ2. When the third region 53 to the fifth region 55 each include no structure body, flat surfaces parallel to the first surface 31a (that is, the flat surfaces at third angle to fifth angle, which are each preferably 0°±5°) serve as the light exit surfaces (second exit surfaces). A part of light transmitted through the optical member 40 exits to the external space using the third region 53 as the exit surface. A part of light transmitted through the optical member 40 exits to the external space using the fourth region 54 as the exit surface. A part of light transmitted through the optical member 40 exits to the external space using the fifth region 55 as the exit surface.

For example, each of the second region 52 to the fifth region 55 may include one structural body or a plurality of structural bodies. A quadrangular pyramid similar to the structural body 100 of the first region 51 can be used. The exit surface of each of the second region 52 to the fifth region 55 corresponds to an inclined surface of the quadrangular pyramid, which is the structural body of each of the second regions 52 to the fifth regions 55. The shape of the structural body is not limited to the quadrangular pyramid and may be other shapes to be described below as long as the second angle to the fifth angle of these inclined surfaces relative to the first surface 31a are narrower than the first angle.

In the example illustrated in FIG. 1, the shape of the outer periphery (first outer periphery) of the optical member 40 in the top view is a square having four vertices: a first vertex V1, a second vertex V2, a third vertex V3, and a fourth vertex V4. The shape of the outer periphery of the optical member 40 in the top view is not limited to a square and may be a rectangle, a trapezoid, or another rectangular shape. The shape of the outer periphery of the optical member 40 is not limited to a quadrangle and can be any convex polygon other than the quadrangle.

In the following, when the outer periphery of a figure is presented, the symbols of vertices of the figure may be allocated clockwise. In the case of the outer periphery, the outer periphery in the top view or the plan view may be simply referred to as an outer periphery.

The outer periphery V1, V2, V4, V3 of the optical member 40 includes the first side portion S1, the second side portion S2, a third side portion S3, and a fourth side portion S4. The first side portion S1, the second side portion S2, the third side portion S3, and the fourth side portion S4 are line segments of the same length. The first side portion S1 and the fourth side portion S4 are parallel to each other. The second side portion S2 and the third side portion S3 are parallel to each other. The first side portion S1 and the fourth side portion are orthogonal to the second side portion S2 and the third side portion S3.

The first vertex V1 is a point where the first side portion S1 intersects the second side portion S2. The second vertex V2 is a point where the first side portion S1 intersects the third side portion S3. The third vertex V3 is a point where the second side portion S2 intersects the fourth side portion S4. The fourth vertex V4 is a point where the third side portion S3 intersects the fourth side portion S4.

The second region 52 is a region included in a region R1 including the first vertex V1. The third region 53 is a region included in a region R2 including the second vertex V2. The fourth region 54 is a region included in a region R3 including the third vertex V3. The fifth region 55 is a region included in a region R4 including the fourth vertex V4. More details are as follows.

The region R1 is a region defined with a straight line connecting the first vertex V1 to a first point P1 on the first side portion S1, a straight line connecting the first point P1 to a second point P2 on the second side portion S2, and a straight line connecting the second point P2 to the first vertex V1. The second region 52 is a region included in the region R1. The first point P1 is a point at a position closer to the first vertex V1 than a point bisecting the first side portion S1. The second point P2 is a point closer to the first vertex V1 than a point bisecting the second side portion S2.

The region R2 is a region defined with a straight line connecting the second vertex V2 to a third point P3 on the first side portion S1, a straight line connecting the third point P3 to a fourth point P4 on the third side portion S3, and a straight line connecting the fourth point P4 to the second vertex V2. The third region 53 is a region included in the region R2. The third point P3 is a point at a position closer to the second vertex V2 than a point bisecting the first side portion S1. The fourth point P4 is a point closer to the second vertex V2 than a point bisecting the third side portion S3.

The region R3 is a region defined with a straight line connecting the third vertex V3 to a fifth point P5 on the second side portion S2, a straight line connecting the fifth point P5 to a sixth point P6 on the fourth side portion S4, and a straight line connecting the sixth point P6 to the third vertex V3. The fourth region 54 is a region included in the region R3. The fifth point P5 is a point at a position closer to the third vertex V3 than a point bisecting the second side portion S2. The sixth point P6 is a point closer to the third vertex V3 than a point bisecting the fourth side portion S4.

The region R4 is a region defined with a straight line connecting the fourth vertex V4, a seventh point P7 on the third side portion S3, a straight line connecting the seventh point P7 to an eighth point P8 on the fourth side portion S4, and a straight line connecting the eighth point P8 to the fourth vertex V4. The fifth region 55 is a region included in the region R4. The seventh point P7 is a point at a position closer to the fourth vertex V4 than a point bisecting the third side portion S3. The eighth point P8 is a point closer to the fourth vertex V4 than a point bisecting the fourth side portion S4.

In the example of FIG. 1, the outer periphery defining the second region 52 include the first vertex V1. The outer periphery of the second region 52 has one side parallel to the first side portion S1 and has one side parallel to the second side portion S2. The shape of the outer periphery of the second region 52 is a square.

In the example of FIG. 1, the third region 53 to the fifth region 55 each have an outer periphery having the same shape as the outer periphery of the second region 52. The third region 53 is a region included in the region R2. The outer periphery of the third region 53 includes the second vertex V2. The outer periphery of the third region 53 has one side parallel to the first side portion S1 and has one side parallel to the third side portion S3.

In the example of FIG. 1, the fourth region 54 is a region included in the region R3. The outer periphery of the fourth region 54 includes the third vertex V3. The outer periphery of the fourth region 54 has one side parallel to the second side portion S2 and has one side parallel to the fourth side portion S4.

In the example of FIG. 1, the fifth region 55 is a region included in the region R4. The outer periphery of the fifth region 55 includes the fourth vertex V4. The outer periphery of the fifth region 55 has one side parallel to the third side portion S3 and has one side parallel to the fourth side portion S4.

The shape of the outer periphery of each of the third region 53 to the fifth region 55 is a square, and the area of each of the third region 53 to the fifth region 55 is equal to the area of the second region 52.

In the example illustrated in FIGS. 2 and 3, the optical member 40 includes a positioning groove 41 on one or more lateral surfaces thereof. The light-reflecting member 70 includes a positioning protrusion 71. The positioning groove 41 and the positioning protrusion 71 are located at the same position on the Z-axis. The positioning groove 41 can be fitted into the corresponding positioning protrusion 71. By fitting the positioning protrusion 71 into the corresponding positioning grooves 41, the position of a lower surface of the optical member 40 from the first surface 31a can be accurately set. Thus, the length of the light-transmitting layer 60 in the Z-axis direction can be reliably ensured.

The positioning of the optical member 40 relative to the wavelength conversion member 30 is not limited to the example described above, and other means can also be used. For example, the optical member 40 can include one or more support posts on the lower surface of the optical member 40. When the optical member 40 is rectangular in the plan view and has four corners, four support posts can be disposed at the corresponding four corners of the lower surface of the optical member 40. The outer periphery of each of the support posts disposed at the corresponding one of the four corners may coincide with a part of the outer periphery of the optical member 40 or may be separated from the outer periphery of the optical member 40, in the plan view. The shape of each of the support posts in the plan view is, for example, rectangular or circular. By the optical member 40 including the support posts, the optical member 40 can be disposed on the wavelength conversion member 30 via the light-transmitting layer 60. The support posts disposed at the corresponding four corners can be disposed in any suitable position in the plan view. Each of the support posts disposed at the corresponding one of the four corners, for example, may overlap the second region 52, the third region 53, the fourth region 54, or the fifth region 55, may partially overlap the second region 52, the third region 53, the fourth region 54, or the fifth region 55, or does not have to overlap the second region 52, the third region 53, the fourth region 54, and the fifth region 55, in the plan view.

In addition, by employing a specific method of forming a light-reflecting member, the positioning of the optical member 40 relative to the wavelength conversion member 30 can be achieved. For example, a first intermediate member is provided in which a light-reflecting member is formed over the entire surface of the lateral surface of the optical member 40 in advance. In the first intermediate member, the light-reflecting member is formed so that a lower end of the light-reflecting member coincides with the lower surface of the optical member 40.

Furthermore, a second intermediate member is provided by disposing the light-emitting element 20 and the wavelength conversion member 30 on the substrate 10 and forming a light-reflecting member over the entire lateral surfaces of the light-emitting element 20 and the wavelength conversion member 30. In the second intermediate member, the position of an upper end of the light-reflecting member is set to be higher than the height of the first surface 31a of the wavelength conversion member 30 by the thickness of the light-transmitting layer 60 when the light-reflecting member is formed.

Thereafter, a light-emitting device in which the light-transmitting layer 60 is provided between the wavelength conversion member 30 and the optical member 40 can be formed by joining the lower end of the light-reflecting member of the first intermediate member and the upper end of the light-reflecting member of the second intermediate member. According to this method, it is not necessary to accurately position a protrusion and a groove, and a light-emitting device can be easily formed.

FIG. 4A schematically illustrates an enlarged top view of a portion IVA of the light-emitting device in FIG. 1.

FIG. 4B schematically illustrates a cross-sectional view of a part of the portion IVA taken along line IVB-IVB in FIG. 4A.

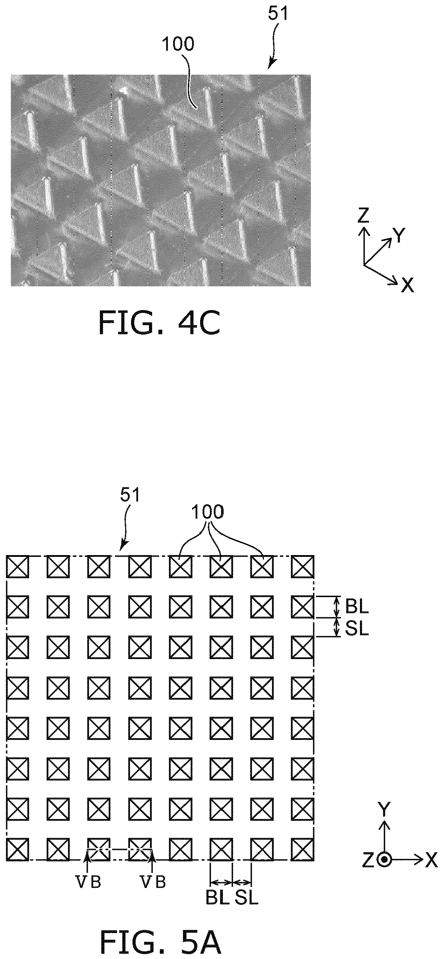

FIG. 4C schematically illustrates an enlarged perspective view of a part of the portion IVA in FIG. 4A.

As illustrated in FIGS. 4A to 4C, the first region 51 of the optical member 40 includes a plurality of the structural bodies 100. In this example, the plurality of structural bodies 100 are continuously arranged in a matrix form without gaps, and thus may be referred to as an array of the structural bodies 100. A single structural body 100 is a quadrangular pyramid. In this example, an area of the single structural body 100 is less than an area of each of the second, third, fourth, and fifth regions, as shown with FIGS. 1 and 4A. The shape of the quadrangular pyramid in the XY plan view is a square. The plane 31b illustrated in FIG. 4B is a virtual plane parallel to the first surface 31a.

The structural body 100 includes four inclined surfaces 101 to 104. In the example shown in FIG. 4B, the structural body 100 is located on the plane 31b that is a virtual plane parallel to the first surface 31a. As illustrated in FIG. 4B, the inclined surface 101 is located opposite to the inclined surface 102. The inclined surface 103 is located opposite to the inclined surface 104. The inclined surface 103 is disposed adjacent to the inclined surfaces 101 and 102. The inclined surface 104 is disposed adjacent to the inclined surfaces 101 and 102. The inclined surface (first exit surface) 101 has an internal angle of the first angle ϕ1 relative to the virtual plane 31b parallel to the first surface 31a. Consequently, the first angle ϕ1 is an internal angle of the inclined surface 101 relative to the first surface 31a. In other words, the internal angle relative to the first surface 31a is an angle formed by the first exit surface 101 and the plane 31b that is the virtual plane parallel to the first surface 31a. The inclined surface 102 located opposite to the inclined surface 101 also has an inclination of the first angle ϕ1 that is the same as the inclined surface 101 in an orientation different from that of the inclined surface 101. Similarly, the remaining two inclined surfaces 103 and 104 each have an inclination of the first angle ϕ1 in different orientations. It is assumed that the first angle ϕ1 of each of the inclined surfaces 101 to 104 refers to an angle of a plane relative to the plane 31b. The plane includes a line segment 100B where the inclined surface of the structural body 100 intersects the plane 31b, and the vertex 100V of the structural body 100.

### Variation of Arrangement of Structural bodies 100

The structural bodies 100 may be arranged continuously without gaps or may be arranged discontinuously with gaps.

FIG. 5A schematically illustrates an enlarged top view of a light-emitting device according to a variation of the embodiment.

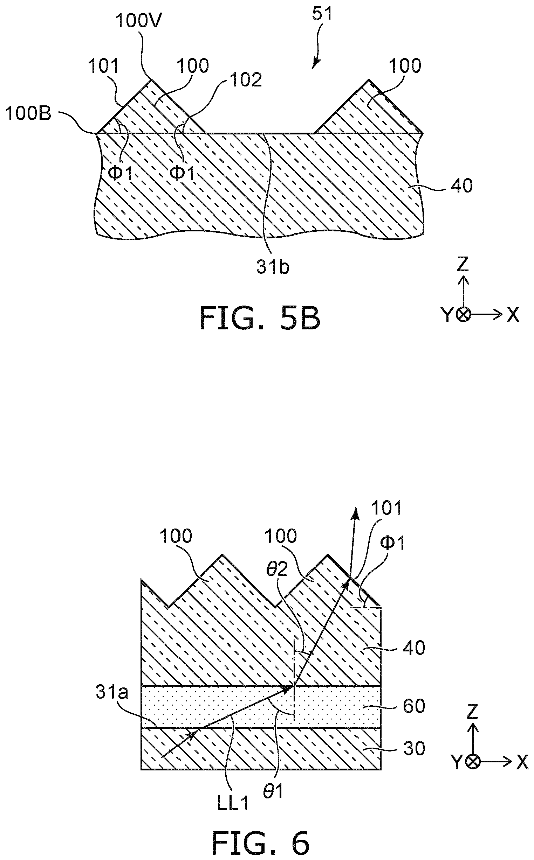

FIG. 5B schematically illustrates a cross-sectional view of the light-emitting device taken along line VB-VB in FIG. 5A.

As illustrated in FIGS. 5A and 5B, the structural bodies 100 are regularly arranged while being spaced apart from one another. In the example illustrated in FIG. 5B, adjacent structural bodies 100 are connected by a flat surface. The structural body 100 includes a square bottom surface with one side length BL. The shortest distance SL between the adjacent structural bodies 100 is the separation distance between two structural bodies 100. In this example, BL = SL. In the example of FIGS. 4A to 4C, SL = 0. The separation distance SL between the structural bodies 100 is not limited to BL = SL or SL = 0 and can be set to discretionary value as long as light with a narrow distribution is emitted from the light-emitting element 20.

In the present embodiment, the structural body 100 is a quadrangular pyramid. However, the shape of the structural body 100 is not limited thereto and may be another shape as long as light with a narrow distribution can be emitted from the light-emitting device 1. For example, the structural body may be another pyramid such as a triangular pyramid or a pentagonal pyramid, or may be a cone, an elliptical cone, or the like. Alternatively, the structural body may be a truncated pyramid or a truncated cone, or may be a hemisphere, a semi-ellipsoid, or the like.

In the light-emitting device 1 according to the embodiment, the upper surface 40T of the optical member 40 includes the second region 52 to the fifth region 55 at the corresponding corner regions, which are regions at the corners of the outer periphery V1, V2, V4, V3. The first region 51 is a region that does not belong to any of the second region 52 to the fifth region 55 and is a region excluding the corner regions.

The first region 51 includes a plurality of the structural bodies 100 that are regularly arranged. This makes it possible to narrow the light incident on the optical member 40.

The optical member 40 is formed of a light-transmitting material. The light-transmitting material has a refractive index higher than the refractive index of the light-transmitting layer 60 and is, for example, light-transmitting resin or glass.

Subsequently, the components of the light-emitting device 1 other than the optical member 40 are described in detail.

The substrate 10 is formed by forming a wiring 12 on a base body 11. In this example, the base body 11 is a square plate-like member in the top view. The base body 11 is preferably formed of an insulating material having high thermal conductivity. The base body 11 is, for example, a ceramic substrate including alumina or the like. The base body 11 is not limited to a ceramic substrate and may be a glass epoxy substrate, a high thermal conductive substrate including polyimide resin fibers, or the like.

Alternatively, the base body 11 may be a sapphire substrate, or a silicon substrate or a metal substrate of which surface is insulated.

The light-emitting element 20 includes a semiconductor structure and a pair of positive and negative electrodes on a lower surface of the semiconductor structure. The pair of positive and negative electrodes are electrically connected to the semiconductor structure. The electrodes are connected to the wiring 12. In the semiconductor structure, for example, a light emitting diode (LED) structure is implemented by layering at least a p-type semiconductor layer, a light-emitting layer, and an n-type semiconductor layer.

The structure of the light-emitting layer may be a structure including a single active layer such as a double heterostructure and a single quantum well (SQW) structure, or a structure including a group of active layers such as a multiple quantum well (MQW) structure. The light-emitting layer can emit visible light or ultraviolet light. For example, visible light may include at least blue to red light. An example of the semiconductor structure including such a light-emitting layer can include InₓAl_{y}Ga_{1 - x-y}N(0 ≤ x, 0 ≤ y, x + y ≤ 1).

The light-emitting element 20 can also include two or more light-emitting layers in the semiconductor structure. For example, the semiconductor structure may have a structure including two or more light-emitting layers between the n-type semiconductor layer and the p-type semiconductor layer or may have a structure in which a structure including the n-type semiconductor layer, the light-emitting layer, and the p-type semiconductor layer layered in this order is repeated twice or more. The two or more light-emitting layers may include, for example, light-emitting layers with different light emission colors or may include light-emitting layers with the same light emission color. The expression "the same light emission color" may include a variation in a range that can be considered as the same light emission color in use. For example, a dominant wavelength of each light emission color may vary by approximately several nanometers. A combination of the light emission colors can be selected as appropriate. For example, when the semiconductor structure includes two light-emitting layers, examples of the combination that can be used include blue light and blue light, green light and green light, red light and red light, ultraviolet light and ultraviolet light, blue light and green light, blue light and red light, or green light and red light.

In this example, a fixing member 24 is disposed around the upper portion of the light-emitting element 20 and between the light-emitting element 20 and the wavelength conversion member 30. The fixing member 24 does not have to be disposed. The fixing member 24 is formed by solidifying an adhesive of which base material is a light-transmitting resin material such as epoxy resin or silicone resin. The fixing member 24 can include particles formed of a resin material having a lower refractive index than the base material. The fixing member 24 can reflect light emitted laterally from the light-emitting element 20 on the inner surface thereof and guide the reflected light upward, so that light extraction can be improved.

The wavelength conversion member 30 is disposed on the light-emitting element 20. In the plan view, the wavelength conversion member 30 is larger than the light-emitting element 20. In the wavelength conversion member 30, for example, a phosphor is dispersed in a base material formed of a light-transmitting resin material. The phosphor absorbs a part of the light emitted from the light-emitting element 20 and emits light with a wavelength different from that of the light emitted from the light emitting element 20. In an example, the light-emitting element 20 emits blue light, and the phosphor absorbs the blue light emitted from the light-emitting element 20 and emits yellow light. With this configuration, the blue light and the yellow light are mixed, and the light-emitting device 1 emits white light.

Examples of the phosphor that can be used for the wavelength conversion member 30 include: an oxynitride based phosphor such as an yttrium aluminum garnet based phosphor (for example, Y₃(Al,Ga)₅O₁₂:Ce), a lutetium aluminum garnet based phosphor (for example, Lu₃(Al,Ga)₅O₁₂:Ce), a terbium aluminum garnet based phosphor (for example, Tb₃(Al,Ga)₅O₁₂:Ce), a CCA based phosphor (for example, Ca₁₀(PO₄)₆Cl₂:Eu), an SAE based phosphor (for example, Sr₄Al₁₄O₂₅:Eu), a chlorosilicate based phosphor (for example, Ca₈MgSi₄O₁₆Cl₂:Eu), a β-SiAlON based phosphor (for example, (Si,Al)₃(O,N)₄:Eu), or an α-SiAlON based phosphor (for example, Ca(Si,Al)₁₂(O,N)₁₆:Eu); a nitride based phosphor such as an SLA based phosphor (for example, SrLiAl₃N₄:Eu), a CASN based phosphor (for example, CaAlSiN₃:Eu), or an SCASN based phosphor (for example, (Sr,Ca)AlSiN₃:Eu); a fluoride based phosphor such as a KSF based phosphor (for example, K₂SiF₆:Mn), a KSAF based phosphor (for example, K₂Si_{0.99}Al_{0.01}F_{5.99}:Mn), or an MGF based phosphor (for example, 3.5MgO· 0.5MgF₂·GeO₂:Mn); a phosphor having a perovskite structure (for example, CsPb(F,Cl,Br,I)₃), or a quantum dot phosphor (for example, CdSe, InP, AgInS₂, or AgInSe₂). As the phosphor added to the base material of the wavelength conversion member, one type of a phosphor may be used, or a plurality of types of phosphors may be used.

The light-transmitting layer 60 is a layer having a refractive index lower than the refractive index of the optical member 40. The light-transmitting layer 60 is, for example, a layer of air. As long as the refractive index of the light-transmitting layer 60 is lower than the refractive index of the optical member 40, the light-transmitting layer 60 is not limited to a layer of air and may be formed of other materials. The light-transmitting layer 60 preferably has a refractive index close to the refractive index of a vacuum and may include other substances.

The thickness of the light-transmitting layer 60 may be thinner than the thicknesses of the optical member 40 and the wavelength conversion member 30 as long as light to be incident on the optical member 40 can be refracted upward.

In the example illustrated in FIG. 3, the light-reflecting member 70 surrounds the light-emitting element 20, the fixing member 24, the wavelength conversion member 30, the light-transmitting layer 60, and the optical member 40 so as to cover the lateral surfaces of the light-emitting element 20, the fixing member 24, the wavelength conversion member 30, the light-transmitting layer 60, and the optical member 40. The light-reflecting member 70 also covers the lower surface of each of the light-emitting element 20 and the wavelength conversion member 30.

The light-reflecting member 70 reflects light emitted from the lateral surfaces of the light-emitting element 20, the fixing member 24, the wavelength conversion member 30, the light-transmitting layer 60, and the optical member 40, and light emitted from the lower surface of each of the light-emitting element 20 and the wavelength conversion member 30. A part of the light reflected by the light-reflecting member 70 is directed upward and contributes to the narrow light distribution of the light-emitting device 1.

The light-reflecting member 70 is formed of, for example, a resin material containing a light diffusing material, and is white as a whole. Examples of the light diffusing material that can be used include titanium oxide, silica, alumina, zinc oxide, or glass. Such a light-reflecting member 70 has a light reflectance of 60% or more, preferably 90% or more.

In the specific examples described above, a case in which one light-emitting element 20 and one optical member 40 are applied to one substrate 10 has been described; however, the present embodiment is not limited thereto. For example, a plurality of light-emitting elements may be disposed on one substrate, and a plurality of optical members may be disposed on the corresponding light-emitting elements. Moreover, a plurality of light-emitting elements may be disposed on one substrate, and one optical member may be commonly disposed on the plurality of light-emitting elements. In any case, light-transmitting layers of substantially equal thickness are disposed between the wavelength conversion member and the optical member on the light-emitting element.

### Light Emission of Light-Emitting Device 1

First, light emission through the light-transmitting layer 60 and the structural body 100 is described.

FIG. 6 is a schematic cross-sectional diagram to explain light emission of the light-emitting device according to the embodiment.

FIG. 6 illustrates the wavelength conversion member 30, the light-transmitting layer 60, the optical member 40, and the structural bodies 100, which are a part of the light-emitting device 1 according to the embodiment. The arrows in FIG. 6 indicate how one light beam LL1 of light passing through the light-emitting device 1 travels through each medium while being refracted. The dashed-dotted line in FIG. 6 is a straight line parallel to an optical axis and denotes a reference line of an incident angle and an exit angle. The optical axis is parallel to the Z-axis.

As illustrated in FIG. 6, the light beam LL1 emitted from the light-emitting element 20 and incident on the wavelength conversion member 30 travels straight through the wavelength conversion member 30 and is incident on the light-transmitting layer 60. The light beam LL1 incident on the light-transmitting layer 60 travels straight through the light-transmitting layer 60 and is incident on the optical member 40.

Because the refractive index of the light-transmitting layer 60 is lower than the refractive index of the optical member 40, an incident angle θ2 of the optical member 40 is narrower than an exit angle θ1 of the light-transmitting layer 60 according to the Snell's law.

The light beam LL1 incident on the optical member 40 at the incident angle θ2 travels straight as is and exits from the inclined surface 101 of the structural body 100. Because the inclined surface 101 has the set first angle ϕ1 so that the exiting light beam is directed upward, the narrow light distribution of the light-emitting device 1 is achieved.

The principle that light exiting from the light-transmitting layer 60 is narrowed by the optical member 40 is described in detail by referring to light emission of a light-emitting device according to a comparative example.

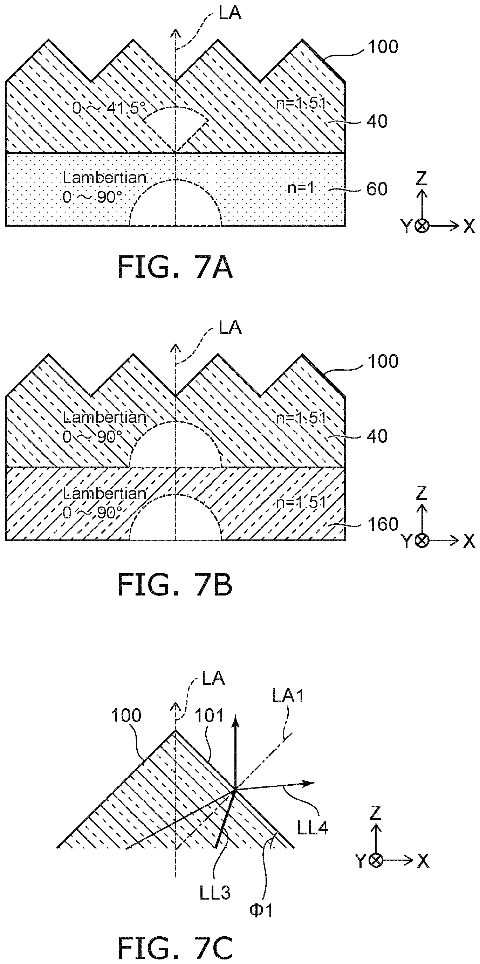

FIG. 7A is a schematic cross-sectional diagram to explain light emission of the light-emitting device according to the embodiment.

FIG. 7B is a schematic cross-sectional diagram to explain light emission of the light-emitting device according to the comparative example.

FIG. 7A schematically illustrates directivity of light having a Lambertian light distribution characteristic when the refractive index n of the light-transmitting layer 60 is 1 and the refractive index n of the optical member 40 is 1.51.

FIG. 7B schematically illustrates directivity of light having a Lambertian light distribution characteristic when a light-transmitting member having the same refractive index n = 1.51 as the optical member 40 is used instead of the light-transmitting layer 60.

In FIGS. 7A and 7B, LA denotes an optical axis, which is shown to be parallel to the Z-axis.

As illustrated in FIG. 7A, the light having the Lambertian light distribution characteristic that have passed through the light-transmitting layer 60 having a refractive index n = 1 is incident on the optical member 40 having a refractive index n = 1.51, and thus a light distribution angle in the optical member 40 is narrowed up to 41.5°.

As illustrated in FIG. 7B, light passing through the members having the same refractive index remains in the Lambertian light distribution.

The following describes that narrowly distributed light is incident on the optical member 40, so that the light exiting from the structural body 100 is further directed upward, resulting in a narrower light distribution.

FIG. 7C is another schematic cross-sectional diagram to explain light emission of the light-emitting device according to the embodiment.

In FIG. 7C, a portion of the structural body 100 is enlarged, and light beams LL3 and LL4 having two types of angles are indicated by two arrows. In the example of FIG. 7C, the first angle ϕ1 is set to 45°. LA denotes the optical axis and is parallel to the Z-axis. LA1 denotes a straight line orthogonal to the inclined surface 101, represents an auxiliary line having the first angle ϕ1 relative to the optical axis LA, and denotes a reference line for an exit angle of light exiting from the structural body 100 and an incident angle of light incident on the external space, with respect to the inclined surface 101. It is assumed that the inclined surface 101 has a first angle and the first angle is 45°.

As illustrated in FIG. 7C, because the refractive index of the structural body 100 is larger than the refractive index of the external space, which is the air, the angle of incidence to the external space is larger than an exit angle from the structural body 100 of a light beam traveling through the structural body 100. The light beam LL3 is a light beam traveling through the structural body 100 at an angle in a range from 0° to 45° relative to the optical axis LA. Thus, when the light beam LL3 exits from the inclined surface 101, an angle of the light beam LL3 relative to the optical axis decreases. That is, the light beam LL3 is further refracted upward.

Because the light beam LL4 travels through the structural body 100 at an angle in a range from 45° to 90° relative to the optical axis LA, an angle of the light beam LL4 relative to the optical axis LA increases when the light beam LL4 exits from the inclined surface 101. That is, in the light from the structural body 100 of the light beam LL4, components of light going upward are further reduced.

As described with reference to FIG. 7A, in the light-emitting device 1 according to the present embodiment, light traveling through the optical member 40 is converged to narrower light distribution from the Lambertian light distribution. In this case, as long as the ratio of the refractive index of the optical member 40 to the refractive index of the light-transmitting layer 60 is as illustrated in FIG. 7A, the light in the optical member 40 is narrowed to 41.5°. Thus, in the light traveling through the optical member 40, because a light beam with an angle such as the light beam LL4 illustrated in FIG. 7C is less likely to exist in the optical member 40, most of the light beams traveling through the optical member 40 are further narrowed and exited from the structural body 100 to the external space.

In a more general case, the angle of the inclined surface 101 is the first angle ϕ1, and in order for the light exiting from the inclined surface 101 to include more components in the positive direction of the Z-axis, it is desirable that light exited from the light-transmitting layer 60 is narrowed at the first angle ϕ1 or less when being incident on the optical member 40.

The following describes that the narrowing of light distribution is hindered when each of the second region 52 to the fifth region 55 includes a structural body 100a identical to the structural body 100 and light is emitted via the structural body 100a, and describes that the second region 52 to the fifth region 55 are made flat not to hinder the narrowing of light distribution.

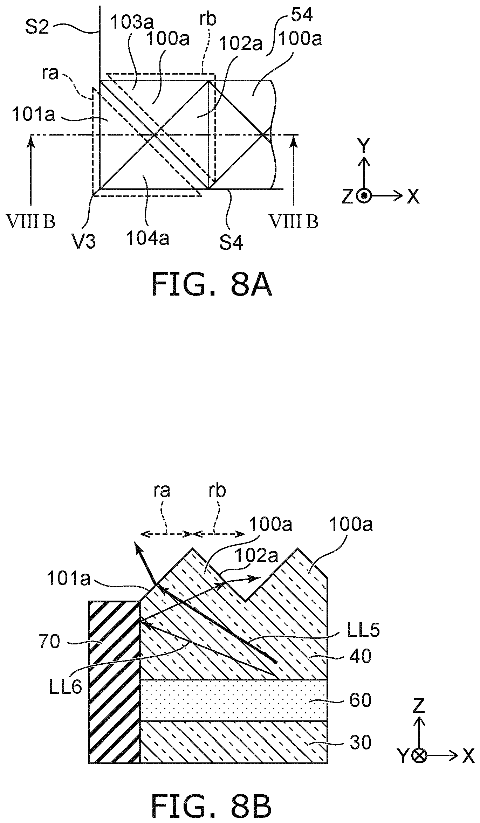

FIG. 8A schematically illustrates an enlarged top view of a part of a light-emitting device according to a comparative example, to explain light emission thereof.

FIG. 8B schematically illustrates a cross-sectional view of a part of a light-emitting device according to a comparative example taken along line VIIIB-VIIIB in FIG. 8A, to explain light emission thereof.

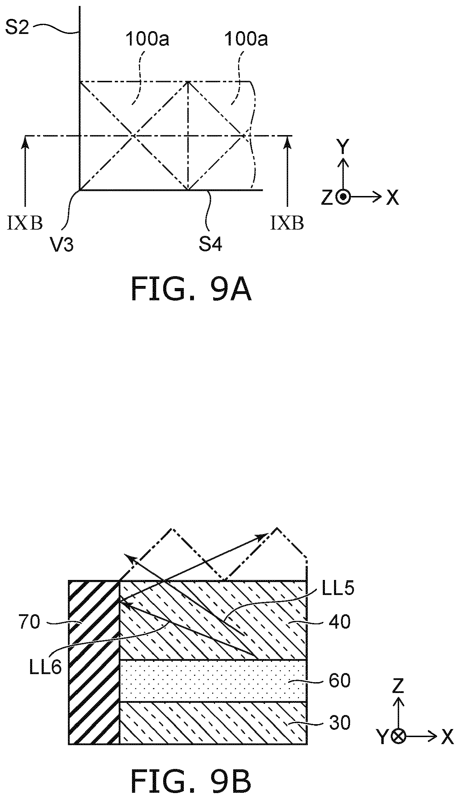

FIG. 9A schematically illustrates an enlarged top view of a part of the light-emitting device according to the embodiment, to explain light emission thereof.

FIG. 9B schematically illustrates a cross-sectional view of a part of the light-emitting device according to the embodiment taken along line IXB-IXB in FIG. 9A, to explain light emission thereof.

For convenience of explanation, the light emission of the light-emitting device according to the embodiment is described after describing the light emission of the light-emitting device according to the comparative example.

In FIGS. 8A and 8B, a part of the optical member 40 is illustrated, and a portion corresponding to the fourth region 54 of the light-emitting device 1 according to the embodiment is enlarged. The light-emitting device according to the comparative example illustrated in FIGS. 8A and 8B is different from the light-emitting device 1 according to the embodiment in that the fourth region 54 includes the structural bodies 100a. The configuration of the light-emitting device according to the comparative example is the same as the configuration of the light-emitting device 1 according to the embodiment in the other respects.

FIGS. 8A and 8B illustrate that the brightness of light in a region rb is lower than the brightness of light in a region ra.

As illustrated in FIGS. 8A and 8B, the structural body 100a includes four inclined surfaces 101a to 104a. The arrangement and shape of the inclined surfaces 101a to 104a are the same as those of the inclined surfaces 101 to 104 described with reference to FIGS. 4A and 4B, respectively. In the structural body 100a, one of four internal angles of a bottom surface of the structural body 100a coincides with the position of the third vertex V3. More specifically, the position of the vertex of an internal angle formed by the inclined surfaces 101a and 104a is the position of the third vertex V3. It is assumed that on the bottom surface of the structural body 100a, a bottom side belonging to the inclined surface 101a is on the second side portion S2 and a bottom side belonging to the inclined surface 104a is on the fourth side portion S4.

The regions ra and rb are regions of inclined surfaces that bisect the inclined surfaces 101a to 104a. The region ra includes the inclined surfaces 101a and 104a, and the region rb includes the inclined surfaces 102a and 103a. That is, the region ra is a region closer to the third vertex V3 than the region rb. In FIG. 8A, broken lines representing the regions ra and rb are shifted from solid lines representing the inclined surfaces 101a to 104a in order to distinguish the regions ra and rb and the inclined surfaces 101a to 104a from each other.

Light exiting from the structural body 100a exits from the light-emitting element 20 disposed on the region more central than a region including the structural body 100a. As illustrated in FIG. 8B, the light emitted from the light-emitting element 20 is directed in the negative direction of the X-axis.

Among light beams constituting such light, a light beam LL5 illustrated in FIG. 8B is incident on the structural body 100a. In this case, an angle of incidence on the structural body 100a is equal to or less than the first angle ϕ1 relative to the optical axis parallel to the Z-axis. Thus, in the structural body 100a, light exiting from the inclined surface 101a includes more components in the positive direction of the Z-axis as described with reference to FIG. 7C, and exiting light has an upwardly directed light distribution characteristic.

Alight beam LL6 illustrated in FIG. 8B is a light beam having less component in the positive direction of the Z-axis than the light beam LL5. Thus, the light beam LL6 is reflected by the light-reflecting member 70 toward the positive direction of the X-axis before being incident on the structural body 100a. The light beam LL6 reflected by the light-reflecting member 70 is incident on the structural body 100a. In this case, an angle of incidence on the structural body 100a is larger than the first angle ϕ1 relative to the optical axis parallel to the Z-axis. Thus, as described with reference to FIG. 7C, components in the positive direction of the Z-axis of light exiting from the inclined surface 102a are reduced.

Consequently, the brightness of light exiting from the inclined surface 102a is lower than the brightness of light exiting from the inclined surface 101a.

In the above, the behavior in the X-axis direction has been described, but light travels while spreading on the XY plane, and a behavior in the Y-axis direction is similar to the behavior in the X-axis direction. That is, in the top view of the light-emitting device 1, the brightness of light exiting from the inclined surface 103a is lower than the brightness of light exiting from the inclined surface 104a. As a result, among the four inclined surfaces of the structural body 100a, the brightness of light exiting from the inclined surfaces 101a and 104a closer to the third vertex V3 is increased, and the brightness of light exiting from the inclined surfaces 102a and 103a farther from the third vertex V3 is decreased, so that the brightness of the structural body 100a included in a corner region is decreased as a whole.

In the above, the fourth region 54, which is one corner region of the upper surface 40T, has been described. However, the same applies to the second region 52, the third region 53, and the fifth region 55, which are the other corner regions. With this configuration, when each of the corner regions of the upper surface 40T includes the structural body 100a including the inclined surfaces, the brightness of light exiting from an inclined surface further from each of the vertices V1 to V4 of the corresponding corner regions is lower than the brightness of light exiting from an inclined surface closer to each of the vertices V1 to V4, so that the brightness of the structural body 100a is decreased. The brightness of light exiting from each structural body is lower in the structural body 100a included in a corner region more significantly affected by light reflected by the light-reflecting member 70 than in the structural body 100 included in the central portion of the upper surface 40T less significantly affected by light reflected by the light-reflecting member 70.

As illustrated in FIGS. 9A and 9B, in the light-emitting device 1 according to the embodiment, the corner region including the third vertex V3 does not include the structural body 100a. In FIGS. 9A and 9B, for ease of comparison with FIGS. 8A and 8B, portions corresponding to the structural bodies 100a illustrated in FIGS. 8A and 8B are indicated by two-dot chain lines.

As illustrated in FIG. 9B, light emitted from the light-emitting element 20 includes the light beam LL5 exiting from the optical member 40 and the light beam LL6 reflected by the light-reflecting member 70, similarly to the case described with reference to FIG. 8B. The angles at which the light beams LL5 and LL6 travel are the same as in FIG. 8B.

The light beam LL5 illustrated in FIG. 9B exits from the optical member 40. The light beam LL6 illustrated in FIG. 9B is reflected by the light-reflecting member 70 and then exits from the optical member 40. Each of the light beams LL5 and LL6 from the optical member 40 has a higher brightness than the light beam exiting from the structural body 100a described with reference to FIGS. 8A and 8B. In the top view, the brightness of light including the light beam LL5 and directed toward the outside of the optical member 40 and the brightness of light including the light beam LL6 and directed toward the inside of the optical member 40 are approximately the same as each other. The light beams LL5 and LL6 illustrated in FIG. 9B exit to an external space having a lower refractive index than the optical member 40, and thus an incident angle on to the external space from the optical member 40 is larger than an exit angle from the optical member 40. Thus, both the light beams LL5 and LL6 exiting from the optical member 40 each have slightly less components in the positive direction of the Z-axis.

The same applies to the second region 52, the third region 53, and the fifth region 55, which are the other corner regions. Consequently, when the corner region does not include the structural body 100a, the difference in brightness between the central portion and the corner region is reduced, and the light-emitting device 1 with narrower light distribution and improved brightness is achieved.

The shapes and sizes of the second region 52 to the fifth region 55 are appropriately set with respect to the shape of the optical member 40. The following case is described as an example.

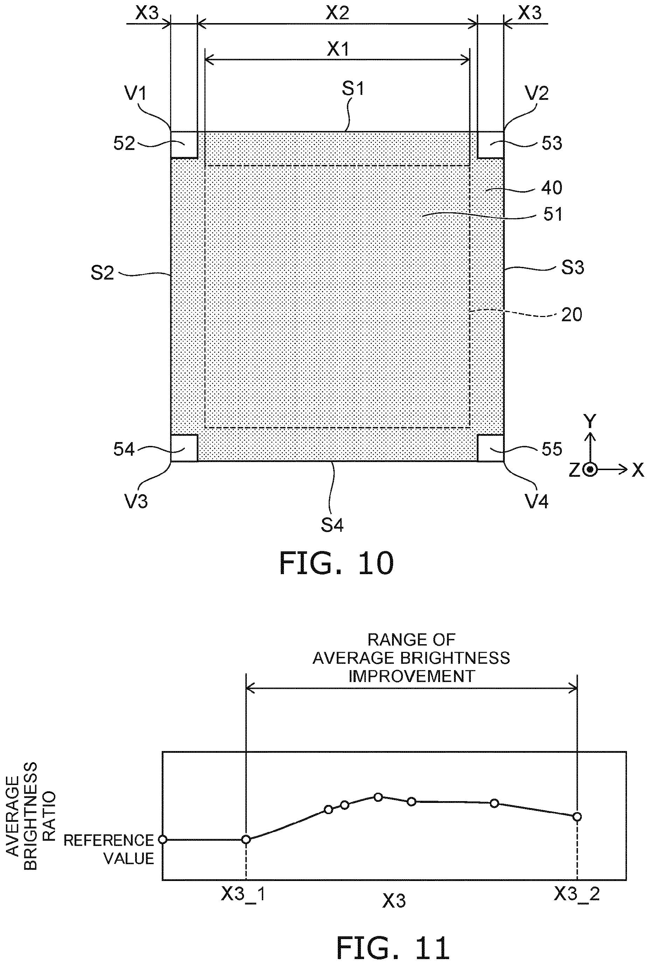

FIG. 10 is a schematic top view diagram to explain definitions of parameters related to the brightness of the light-emitting device according to the embodiment.

As illustrated in FIG. 10, lengths X1, X2, and X3 are defined. X1 is the length of one side of the light-emitting element 20. X2 is the shortest length of the first region 51 between the second region 52 and the third region 53. X3 is the length of one side of each of the second region 52 and the third region 53. It is noted that the length of one side of each of the fourth region 54 and the fifth region 55 is also X3.

X1 is a given size of the light-emitting element 20 and is a fixed value in this example. X2 is a value that can be changed by changing the length X3 of one side of each of the second region 52 and the third region 53. It is assumed that the second region 52 to the fifth region 55 are squares of the same size. The brightness of the upper surface 40T with respect to the length X3 of one side of the square forming each of the second region 52 to the fifth region 55 is calculated. For example, an optical simulator or the like can be used for calculating the brightness.

FIG. 11 is a graph presenting relative brightness according to the definitions of the parameters of FIG. 10.

As illustrated in FIG. 11, the vertical axis in the graph denotes an average brightness ratio. The average brightness ratio is the ratio of an average brightness to a reference value. The average brightness is brightness obtained by simply averaging the brightness on the upper surface 40T. In this example, the reference value for the average brightness is average brightness when the entire surface of the upper surface 40T includes the regularly and continuously arranged structural bodies 100 (that is, each of the second region 52 to the fifth region 55 includes the same structural body as the structural body 100). The higher the average brightness ratio, the narrower the light distribution, and therefore high brightness is obtained in a wider range of the upper surface 40T.

The horizontal axis in the graph denotes the length of one side of the second region 52 and is the length X3 of one side of each of the second region 52 to the fifth region 55 illustrated in FIG. 10.

In this graph, the average brightness ratio exceeds the reference value when X3 is larger than X3_1 and X3 is smaller than X3_2. The length X0 of one side of the optical member 40 is given, and the shortest length X2 of the first region 51 between the second region 52 and the third region 53 is given by X3_1 and X3_2. The value of X2 given by X3_1 and X3_2 is in a range from X1 × 0.9 to X1 × 1.1. That is, the length of one side of each of the second region 52 to the fifth region 55 is set to X3 so that the shortest length X2 of the first region 51 between the second region 52 and the third region 53 is in a range from 90% to 110% of the length X1 of one side of the light-emitting element 20, which makes it possible to achieve the light-emitting device 1 with narrower light distribution and improved brightness.

### Variations

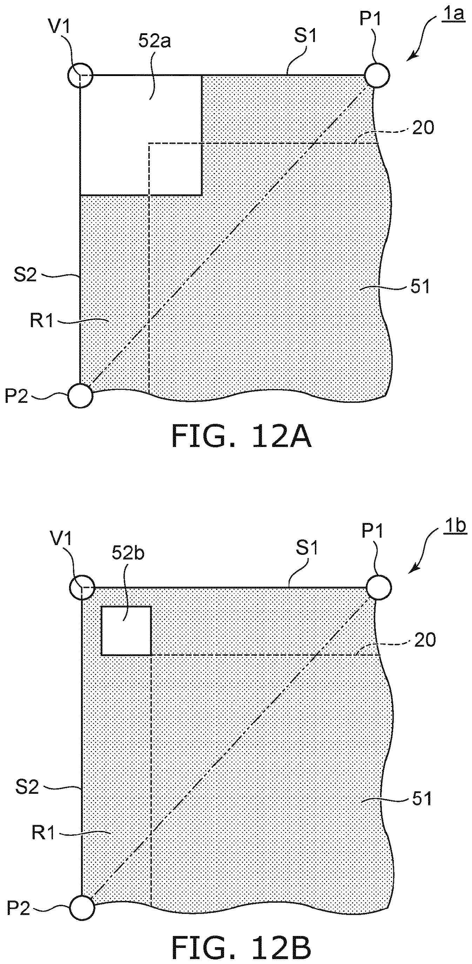

FIGS. 12A, 12B, 13A, 13B, 14A, and 14B schematically illustrate top views of light-emitting devices according to variations of the embodiment.

It has been described as: the second region 52 is a square including a side parallel to the first side portion S1 and a side parallel to the second side portion S2 and including the first vertex V1 in the vertices of the second region 52, the third region 53 is a square including a side parallel to the first side portion S1 and a side parallel to the third side portion S3 and including the second vertex V2 in the vertices of the third region 53, the fourth region 54 is a square including a side parallel to the second side portion S2 and a side parallel to the fourth side portion S4 and including the third vertex V3 in the vertices of the fourth region 54, and the fifth region 55 is a square including a side parallel to the third side portion S3 and a side parallel to the fourth side portion S4 and including the fourth vertex V4 in the vertices of the fifth region 55. However, the shape of each of the second region to the fifth region is not limited to a square. The light-emitting devices of the following variations include second to fifth regions of different shapes.

FIGS. 12A, 12B, 13A, 13B, 14A, and 14B illustrate the shapes of the second region, and the third region to the fifth region have similar shapes.

As illustrated in FIG. 12A, in a light-emitting device 1a according to a variation, the upper surface 40T includes a second region 52a. The second region 52a is a square including the first vertex V1 as one of its vertices. The length of one side of the second region 52a is longer than half the length obtained by subtracting the length of one side of the light-emitting element 20 from the length of one side of the optical member 40 in a top view. Consequently, the second region 52a includes both a region outside the light-emitting element 20 and a region inside (i.e., overlapping) the light-emitting element 20 in the top view. As for the length of one side of the second region 52a, it is preferable that the shortest length of the first region 51 between the second region 52 and the third region 53 in the case of the length of one side of the second region 52a at that time is 90% or more of the length of one side of the light-emitting element 20 as described with reference to FIGS. 10 and 11.

As illustrated in FIG. 12B, in a light-emitting device 1b according to another variation, the upper surface 40T includes a second region 52b. The second region 52b is a square. The second region 52b does not include the first vertex V1. Consequently, the first region 51 is located between the first vertex V1 and the second region 52b. The first region 51 is also located between the first side portion S1 and the second region 52b. The first region 51 is also located between the second side portion S2 and the second region 52b.

The shape of each of the second region to the fifth region is not limited to a square.

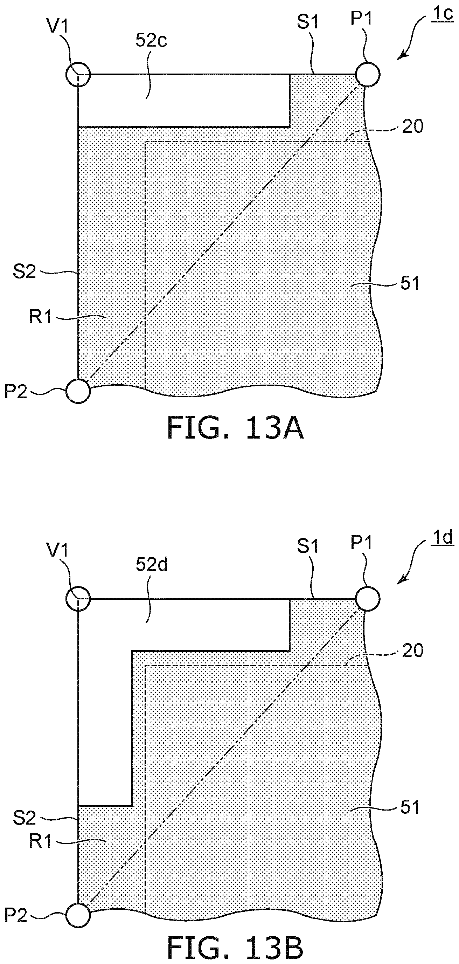

As illustrated in FIG. 13A, in a light-emitting device 1c according to another variation, the upper surface 40T includes a second region 52c. The second region 52c is a rectangle including the first vertex V1 as one of its vertices. In this example, the second region 52c is a rectangle including a long side on the first side portion S1. When the second region is a rectangle, the long side of the rectangle is not limited to being on the first side portion S1 and may be on the second side portion S2.

As illustrated in FIG. 13B, in a light-emitting device 1d according to another variation, the upper surface 40T includes a second region 52d. The second region 52d has a shape obtained by combining two rectangles including the first vertex V1 as one of their vertices. The second region 52d has a combined shape of a rectangle including a long side on the first side portion S1 and a rectangle including a long side on the second side portion S2.

The shape of each of the second region to the fifth region is not limited to a square or a rectangle.

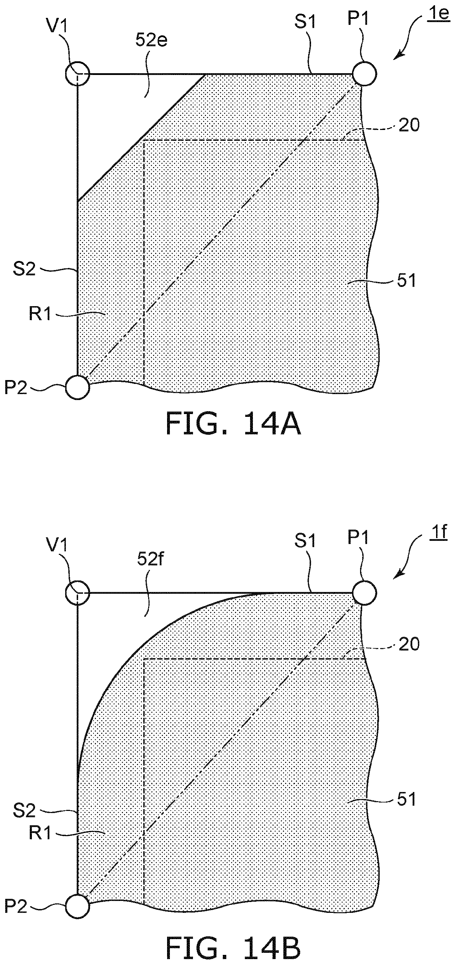

As illustrated in FIG. 14A, in a light-emitting device 1e according to another variation, the upper surface 40T includes a second region 52e. The second region 52e is an isosceles right triangle including the first vertex V1 as one of its vertices. The second region 52e is an isosceles right triangle including a side on the first side portion S1 and a side on the second side portion S2.

The shape of each of the second region to the fifth region is not limited to a polygon such as a triangle or a rectangular shape.

As illustrated in FIG. 14B, in a light-emitting device 1f according to another variation, the upper surface 40T includes a second region 52f. The second region 52f has a shape including the first vertex V1 as one of its vertices. The second region 52f includes a linear side including the first vertex V1 on the first side portion S1 and a linear side including the first vertex on the second side portion S2. The two sides of the second region 52f are connected by an arc at an end portion opposite to the first vertex V1. The arc of the second region 52f is an arc of a circle having a center in the first region 51. The second region is not limited to the above-described shape and may be an arc of a circle having a center in the second region.

The shapes of the second region to the fifth region need not to be the same shape, and the shape of each region is determined so that average brightness in the top view is improved. Even though the shape of the outer periphery of the optical member 40 in the top view is the shape of another convex polygon other than a square, an appropriate shape for each corner region is selected in accordance with the shape or the like of the convex polygon.

Advantages of the light-emitting device 1 according to the embodiment are described. The light-emitting device 1 according to the embodiment includes the optical member 40 and the light-transmitting layer 60 having a lower refractive index than the optical member 40. According to these elements, the light distribution of light exiting from the light-transmitting layer 60 is narrowed by the optical member 40. Furthermore, the optical member 40 having a square outer periphery includes the structural bodies 100 in the first region 51, which is a region excluding at least corner regions of the square. Because the structural body 100 includes the inclined surface 101 having the first angle ϕ1, narrowly distributed light in the optical member 40 is further narrowed and exiting from the inclined surface 101.

In the light-emitting device 1 according to the embodiment, the optical member 40 includes the second region 52 to the fifth region 55 corresponding to the corners of the outer periphery of the square, each including an inclined surface having the second angle ϕ2 narrower than the first angle ϕ1. Thus, the brightness of light emitted from the inclined surface of each of the second regions 52 to the fifth region 55 is not lower than the brightness of light when the second region 52 to the fifth region 55 described with reference to FIGS. 8A and 8B include the structural bodies 100a. Thus, a decrease in brightness in the corner region of the outer periphery of the optical member 40 is suppressed, and the average brightness of light emitted by the light-emitting device 1 is improved.

Although the second region 52 to the fifth region 55 are assumed to be discretely disposed in the corner regions of the optical member having a rectangular shape in the plan view, it is sufficient that each of the second region 52 to the fifth region 55 includes a corner region, and even though adjacent regions among the second regions 52 to the fifth regions 55 are combined together and a plurality of regions are integrated into a unified region, the same advantages as described above can be achieved. For example, the second region 52 and the third region 53 extend in the X-axis direction and are mutually combined, and the fourth region 54 and the fifth region 55 extend in the X-axis direction and are mutually combined. Furthermore, the second region 52 and the fourth region 54 extend in the Y-axis direction and are mutually combined, and the third region 53 and the fifth region 55 extend in the Y-axis direction and are mutually combined. That is, the second region 52 to the fifth region 55 may be combined together, and a region in which these regions are combined may be disposed over the entire outer periphery of the optical member 40 in a plan view. In this case, the shape of the combined region in the plan view can be a quadrangular annular shape.

Any one or both of the wavelength conversion member 30 and the light-transmitting layer 60 does not have to be disposed, and even when they are not disposed, it is of course possible to suppress a decrease in brightness in a corner region by satisfying the relationship between the first angle ϕ1 and the second angle ϕ2 in the first region 51 to the fifth region 55.

According to the embodiment described above, it is possible to achieve a light-emitting device in which a decrease in the brightness of emitted light is suppressed in the region of a corner of an optical member from which the light exits.

While several embodiments of the present invention have been described above, these embodiments have been presented by way of example and are not intended to limit the scope of the invention. These novel embodiments may be implemented in various other forms and various omissions, substitutions, and changes may be made without departing from the spirit of the invention. These embodiments and variations thereof are included in the scope and spirit of the invention and are within the scope of the invention described in the claims and equivalents thereof. Furthermore, the aforementioned embodiments may be implemented in combination with each other.

Embodiments include the following aspects.

### Supplementary Note 1

A light-emitting device including
a substrate;
a light-emitting element disposed on the substrate;
a wavelength conversion member disposed on the light-emitting element and having a first surface opposite to a surface of the wavelength conversion member facing the light-emitting element;
an optical member having an upper surface and disposed above the first surface;
a light-transmitting layer disposed between the wavelength conversion member and the optical member and having a refractive index lower than a refractive index of the optical member; and
a light-reflecting member surrounding the light-emitting element, the wavelength conversion member, the light-transmitting layer, and the optical member, wherein
the upper surface of the optical member includes a first region including a first exit surface of which internal angle relative to a virtual plane parallel to the first surface is a first angle and a second region adjacent to the first region and including a second exit surface of which internal angle relative to the virtual plane parallel to the first surface is a second angle,
the second angle is narrower than the first angle, and
in a top view,
   the optical member has an outer periphery having a shape of a convex polygon,
   the convex polygon includes a first side portion, a second side portion, and a first vertex where the first side portion intersects the second side portion, and
   the second region is included in a region defined by a straight line connecting the first vertex to a first point on the first side portion that is closer to the first vertex than a point bisecting the first side portion, a straight line connecting the first point to a second point on the second side portion that is closer to the first vertex than a point bisecting the second side portion, and a straight line connecting the second point to the fist vertex.

### Supplementary Note 2

The light-emitting device according to the supplementary note 1 in which the second exit surface is a flat surface with the second angle, and the second angle is 0°.

### Supplementary Note 3

The light-emitting device according to the supplementary note 1 or 2 in which the second region is located outside an outer periphery of the light-emitting element.

### Supplementary Note 4

The light-emitting device according to the supplementary note 1 or 2 in which the second region includes a region inside an outer periphery of the light-emitting element.

### Supplementary Note 5

The light-emitting device according to any one of the supplementary notes 1 to 4 in which
the upper surface of the optical member includes a third region adjacent to the first region, and
in the top view,
the convex polygon further includes a third side portion and a second vertex where the first side portion intersects the third side portion, and
the third region is included in a region defined with a straight line connecting the second vertex to a third point on the first side portion that is closer to the second vertex than the position bisecting the first side portion, a straight line connecting the third point to a fourth point on the third side portion that is closer to the second vertex than a position bisecting the third side portion, and a straight line connecting the fourth point to the second vertex.

### Supplementary Note 6

The light-emitting device according to the supplementary note 5 in which
the upper surface of the optical member includes a fourth region and a fifth region adjacent to the first region, and
in the top view,
the convex polygon further includes a fourth side portion and a third vertex where the second side portion intersects the fourth side portion,
the fourth region is included in a region defined with a straight line connecting the third vertex to a fifth point on the second side portion that is closer to the third vertex than the position bisecting the second side portion, a straight line connecting the fifth point to a sixth point on the fourth side portion that is closer to the third vertex than a position bisecting the fourth side portion, and a straight line connecting the sixth point to the third vertex,
the convex polygon further includes a fourth vertex where the third side portion intersects the fourth side portion, and
the fifth region is included in a region defined with a straight line connecting the fourth vertex to a seventh point on the third side portion that is closer to the fourth vertex than the position bisecting the third side portion, a straight line connecting the seventh point to an eighth point on the fourth side portion that is closer to the fourth vertex than the position bisecting the fourth side portion, and a straight line connecting the eighth point to the fourth vertex.

### Supplementary Note 7

The light-emitting device according to any one of the supplementary notes 1 to 6 in which, in a plan view, the second region has an outer periphery having a rectangular shape or a triangular shape having the first vertex as a vertex.

### Supplementary Note 8

The light-emitting device according to the supplementary note 5 or 6 in which the light-emitting element includes an outer periphery including a side parallel to the first side portion,
each of the second region and the third region has a square shape or a rectangular shape having a side parallel to the first side portion and a side orthogonal to the first side portion, and
a length of a portion of the first region that is parallel to the first side portion and located between the second region and the third region is in a range from 90% to 110% of a length of the side of the light-emitting element.

### Supplementary Note 9

The light-emitting device according to any one of the supplementary notes 1 to 8 in which the upper surface of the optical member includes a pyramid-shaped or cone-shaped region having the first exit surface.

### Supplementary Note 10

The light-emitting device according to the supplementary note 9 in which the pyramid or the cone and one or more additional pyramids or cones on the upper surface of the optical member are continuously and regularly arranged.

### Supplementary Note 11

The light-emitting device according to any one of the supplementary notes 1 to 10 in which the light-transmitting layer is a layer of air, and the light-transmitting layer is located over an entire surface of the first surface of the wavelength conversion member.

### Supplementary Note 12

A light-emitting device including
a substrate;
a light-emitting element disposed on the substrate and having a light emitting surface;
an optical member having an upper surface and disposed above the light emitting surface; and
a light-reflecting member surrounding the light-emitting element and the optical member, wherein
the upper surface of the optical member has a first region having a first exit surface of which internal angle relative to the light emitting surface is a first angle and a second region adjacent to the first region and having a second exit surface of which internal angle relative to the light emitting surface is a second angle,
in a top view,
   the optical member has an outer periphery having a shape of a convex polygon,
   the convex polygon has a first side portion, a second side portion, and a first vertex where the first side portion intersects the second side portion, and
   the second region is included in a region defined with a straight line connecting the first vertex to a first point on the first side portion that is closer to the first vertex than a point bisecting the first side portion, a straight line connecting the first point to a second point on the second side portion that is closer to the first vertex than a point bisecting the second side portion, and a straight line connecting the second point to the first vertex, and
the second angle is narrower than the first angle.

## Claims

1. A light-emitting device comprising:
a substrate;
a light-emitting element disposed on the substrate;
a wavelength conversion member disposed on the light-emitting element and having a first surface opposite to a surface of the wavelength conversion member facing the light-emitting element;
an optical member having an upper surface and disposed above the first surface;
a light-transmitting layer disposed between the wavelength conversion member and the optical member and having a refractive index lower than a refractive index of the optical member; and
a light-reflecting member surrounding the light-emitting element, the wavelength conversion member, the light-transmitting layer, and the optical member, wherein
the upper surface of the optical member includes a first region including a first exit surface of which internal angle relative to a virtual plane parallel to the first surface is a first angle and a second region adjacent to the first region and including a second exit surface of which internal angle relative to the virtual plane parallel to the first surface is a second angle,
the second angle is narrower than the first angle, and
in a top view,
the optical member has an outer periphery having a shape of a convex polygon,
the convex polygon includes a first side portion, a second side portion, and a first vertex where the first side portion intersects the second side portion, and
the second region is included in a region defined by a straight line connecting the first vertex to a first point on the first side portion that is closer to the first vertex than a point bisecting the first side portion, a straight line connecting the first point to a second point on the second side portion that is closer to the first vertex than a point bisecting the second side portion, and a straight line connecting the second point to the fist vertex.

2. The light-emitting device according to claim 1, wherein the second exit surface is a flat surface with the second angle, and the second angle is 0°.

3. The light-emitting device according to claim 1 or 2, wherein the second region is located outside an outer periphery of the light-emitting element.

4. The light-emitting device according to claim 1 or 2, wherein the second region includes a region inside an outer periphery of the light-emitting element.

5. The light-emitting device according to any one of claims 1 to 4, wherein
the upper surface of the optical member includes a third region adjacent to the first region, and
in the top view,
the convex polygon further includes a third side portion and a second vertex where the first side portion intersects the third side portion, and
the third region is included in a region defined with a straight line connecting the second vertex to a third point on the first side portion that is closer to the second vertex than the position bisecting the first side portion, a straight line connecting the third point to a fourth point on the third side portion that is closer to the second vertex than a position bisecting the third side portion, and a straight line connecting the fourth point to the second vertex.

6. The light-emitting device according to claim 5, wherein
the upper surface of the optical member includes a fourth region and a fifth region adjacent to the first region, and
in the top view,
the convex polygon further includes a fourth side portion and a third vertex where the second side portion intersects the fourth side portion,
the fourth region is included in a region defined with a straight line connecting the third vertex to a fifth point on the second side portion that is closer to the third vertex than the position bisecting the second side portion, a straight line connecting the fifth point to a sixth point on the fourth side portion that is closer to the third vertex than a position bisecting the fourth side portion, and a straight line connecting the sixth point to the third vertex,
the convex polygon further includes a fourth vertex where the third side portion intersects the fourth side portion, and
the fifth region is included in a region defined with a straight line connecting the fourth vertex to a seventh point on the third side portion that is closer to the fourth vertex than the position bisecting the third side portion, a straight line connecting the seventh point to an eighth point on the fourth side portion that is closer to the fourth vertex than the position bisecting the fourth side portion, and a straight line connecting the eighth point to the fourth vertex.

7. The light-emitting device according to any one of claims 1 to 6, wherein, in a plan view, the second region has an outer periphery having a rectangular shape or a triangular shape having the first vertex as a vertex thereof.

8. The light-emitting device according to claim 5 or 6, wherein
the light-emitting element has an outer periphery having a side parallel to the first side portion,
each of the second region and the third region has a square shape or a rectangular shape having a side parallel to the first side portion and a side orthogonal to the first side portion, and
a length of a portion of the first region that is parallel to the first side portion and located between the second region and the third region is in a range from 90% to 110% of a length of the side of the light-emitting element.

9. The light-emitting device according to any one of claims 1 to 8, wherein the upper surface of the optical member includes a pyramid-shaped or cone-shaped region having the first exit surface.

10. The light-emitting device according to claim 9, wherein the upper surface of the optical member includes an array of pyramid-shaped or cone-shaped regions, each having the first exit surface.

11. The light-emitting device according to any one of claims 1 to 10, wherein the light-transmitting layer is a layer of air, and the light-transmitting layer is located over an entity of the first surface of the wavelength conversion member.

12. A light-emitting device comprising:
a substrate;
a light-emitting element disposed on the substrate and having a light emitting surface;
an optical member having an upper surface and disposed above the light emitting surface; and
a light-reflecting member surrounding the light-emitting element and the optical member, wherein
the upper surface of the optical member has a first region having a first exit surface of which internal angle relative to the light emitting surface is a first angle and a second region adjacent to the first region and having a second exit surface of which internal angle relative to the light emitting surface is a second angle,
in a top view,
the optical member has an outer periphery having a shape of a convex polygon,
the convex polygon has a first side portion, a second side portion, and a first vertex where the first side portion intersects the second side portion, and
the second region is included in a region defined with a straight line connecting the first vertex to a first point on the first side portion that is closer to the first vertex than a point bisecting the first side portion, a straight line connecting the first point to a second point on the second side portion that is closer to the first vertex than a point bisecting the second side portion, and a straight line connecting the second point to the first vertex, and
the second angle is narrower than the first angle.
